# FASCICULE DE BREVET EUROPEEN

(11) **EP 2 992 685 B1**
(45) Date de publication et mention de la délivrance du brevet: **22.08.2018**
(21) Numéro de dépôt: 14727598.6
(22) Date de dépôt: 29.04.2014
(51) Int. Cl.: H04Q 9/00, G01D 4/00, H04B 3/54, G01D 5/245, G01R 22/06, G06Q 50/06, H04W 4/70

(54) **INTERFACE DE COMMUNICATION ENTRE UN ÉQUIPEMENT ET UN SYSTÈME DE COMPTAGE DE FLUIDE**
SCHNITTSTELLE ZUR KOMMUNIKATION ZWISCHEN EINEM AUSRÜSTUNGSGEGENSTAND UND EINEM FLÜSSIGKEITSMESSSYSTEM
INTERFACE FOR COMMUNICATION BETWEEN AN ITEM OF EQUIPMENT AND A FLUID METERING SYSTEM

(30) Priorité: 30.04.2013 FR 1353991
(43) Date de publication de la demande: 09.03.2016
(73) Titulaire: Electricité de France, 75008 Paris (FR)
(72) Inventeur: DHERBECOURT, Yves, F-92340 Bourg La Reine (FR)
(74) Mandataire: Cabinet Plasseraud
(86) Numéro de dépôt international: PCT/FR2014/051027
(87) Numéro de publication internationale: WO 2014/177806

(56) Documents cités:
- EP-A1- 1 677 270
- EP-A1- 1 850 500
- WO-A1-2013/042100
- WO-A2-02/052407
- US-A1- 2008 117 077

## Description

### Domaine technique

L'objet de la présente invention concerne le domaine du contrôle de la consommation de fluide d'un ou plusieurs équipements dans une installation telle qu'une installation domestique ou industrielle.

Un des objectifs de la présente invention est de faciliter la diffusion des informations entre un compteur de fluide et les équipements d'une installation, et d'assurer dans le même temps la relève de compteurs annexes et le délestage local.

Un des autres objectifs de la présente invention est d'offrir aux consommateurs l'accès à des services d'information intelligents, par exemple en affichant des informations et des conseils en matière de consommation de fluide, ceci afin de maîtriser cette consommation.

Par fluide au sens de la présente invention, il faut comprendre ici dans toute la présente description qui suit toute source énergétique, telle que par exemple l'électricité, l'eau, ou encore le gaz ou le fioul, susceptible d'être consommé par un équipement en vue notamment de son fonctionnement.

### Etat de la technique

Maîtriser la consommation des fluides est devenu un défi quotidien et grandissant, ceci tant pour les particuliers que pour les industriels ou encore les collectivités : on comprendra ici que les raisons qui incitent à maîtriser cette consommation sont aussi bien d'ordre économique (coûts financiers élevés) que d'ordre écologique (pollution, ressources naturelles).

Les compteurs de fluide sont généralement basiques, et ne permettent qu'un relevé de consommation classique pour l'ensemble des équipements d'une installation. Les compteurs les plus performants ne font, au mieux, qu'un relevé de consommation multi-fluide.

Il existe également des compteurs, dits communicants, qui sont configurés pour communiquer avec les équipements situés à l'aval du compteur ; c'est-à-dire ici dans le sens descendant du compteur vers les équipements de l'installation.

Le plus souvent, ces compteurs communicants intègrent un module de communication radio fixe ou amovible.

Cependant, ce type de compteurs communicants présente plusieurs inconvénients.

En effet, ces compteurs présentent une portée radio souvent limitée de sorte que la transmission d'information devient vite impossible entre le compteur et les équipements ; ceci est d'autant plus vrai lorsque le compteur est déporté physiquement de l'installation.

La Demanderesse soumet en outre que chaque compteur ne comporte généralement qu'un seul module de communication radio. Le compteur communique donc selon un seul et unique protocole de communication prédéterminé, qu'il est parfois très difficile de modifier une fois installé.

Ainsi, lorsqu'un module de communication radio est fixe (c'est-à-dire intégré dans le compteur), il est tout simplement impossible de changer le protocole de communication utilisé.

Lorsque le module de communication radio est amovible et que les équipements de l'installation sont configurés chacun pour utiliser des protocoles différents, il est dans ce cas nécessaire de sélectionner un protocole au détriment des autres.

En tout état de cause, quelle que soit la configuration du module de communication radio (amovible/fixe), les compteurs communicants actuels ne permettent de communiquer qu'avec les équipements supportant un seul et même protocole de communication.

De plus, l'utilisation d'un module de communication radio utilisant un protocole de communication sans fil tel que le « *Wifi*® » requiert beaucoup d'énergie électrique ; or, généralement, l'alimentation en électricité du module radio fournie par le compteur est réduite, ce qui empêche l'utilisation de tels protocoles.

Par ailleurs, l'installation de ces modules de communication additionnels est bien souvent très difficile, voire impossible, pour un particulier, notamment lorsque le compteur existant n'est pas direct d'accès (par exemple, lorsque le compteur est dans un coffret ou dans un local technique).

Enfin, la Demanderesse observe que les compteurs communicants ne permettent pas la remontée de donnée des équipements vers le compteur pour fournir un service d'informations pertinent.

La société ENEL, notamment dans le document WO 2012/045357, propose un système « *SmartInfo* » qui communique de façon unidirectionnelle vers l'aval du compteur.

Néanmoins, la solution proposée ici par la société ENEL ne prévoit en aucune manière la possibilité de collecter des informations sur chacun des équipements d'une même installation, et de transmettre ces informations vers l'amont du compteur (par exemple vers le concentrateur).

Le document US 2008/117077 propose quant à lui une interface de communication pour communiquer l'ensemble des données de comptage collectées par le compteur à un concentrateur, jouant le rôle d'un véritable « *datacenter ».*

En effet, comme illustré sur la figure 4 de ce document US 2008/117077, les compteurs 405 collectent des données de comptage et transmettent par des moyens de communication sans fil ces données à l'interface AMR 401 (pour « *Automatic Meter Reading* »),
L'interface 401 communique ensuite ces données au concentrateur 416, par courants porteurs en ligne (technologie CPL).

Cette solution, bien qu'intéressante, ne permet pas de mettre à disposition de l'habitat et du consommateur final l'ensemble des données de comptage collectées par le compteur.

Ainsi, le document US 2008/117077 ne vise qu'à optimiser la relève des données de comptage vers un concentrateur en proposant une passerelle « bidirectionnelle » comportant des moyens de communication sans fil pour communiquer avec l'ensemble des compteurs et des moyens de communication du type CPL pour communiquer avec le concentrateur.

L'état de la technique n'offre pas de solutions intelligentes permettant d'offrir directement aux consommateurs des services d'informations concernant leur consommation de fluides. De plus, si parfois certains compteurs permettent de relever des données de consommation en gaz en plus des données de consommation en électricité, aucun des compteurs communicants dans l'état de la technique ne permet de transmettre d'autres données venant de l'installation.

### Objet et Résumé de la présente invention

L'objet de la présente invention vise à améliorer la situation décrite ci-dessus.

L'objet de la présente invention propose à cet effet un dispositif de communication entre un ou plusieurs équipements d'une installation et un compteur de fluide.

Selon l'invention, un tel compteur de fluide est configuré pour compter une quantité de fluide consommée par l'ensemble des équipements de l'installation.

Avantageusement, le ou les équipements de l'installation et le compteur de fluide sont reliés au réseau de fluide de l'installation.

On comprendra ici que, dans le cas spécifique d'un compteur électrique, le ou les équipements de l'installation et le compteur électrique sont reliés au réseau électrique de l'installation.

Pour favoriser la communication entre les différentes entités de l'infrastructure décrite ci-dessus, le dispositif selon la présente invention comporte avantageusement :
- une première interface de communication qui est configurée pour communiquer par courants porteurs en ligne, ou CPL, avec le compteur, et
- une deuxième interface de communication qui est configurée pour communiquer sans fil avec chaque équipement.

Avantageusement, chacune des première et deuxième interfaces est configurée pour une communication bidirectionnelle.

Un tel dispositif vient donc s'interfacer entre le compteur et les équipements d'une installation (par exemple une installation domestique ou industrielle) et assure une communication bidirectionnelle entre le compteur et les équipements de l'installation, ceci quand bien même le compteur serait déporté des équipements (par exemple dans une colonne en dehors d'une habitation), et ne pourrait pas dans ce cas communiquer directement avec les équipements.

Ceci est différent du document US 2008/117077 qui propose une passerelle qui s'interface entre le compteur de fluide et le concentrateur et qui permet au compteur de de communiquer directement avec l'amont du compteur (c'est-à-dire avec notamment le concentrateur et le système d'information comptage) pour optimiser la relève des données de comptage.

Dans cette architecture nouvelle proposée dans le cadre de la présente invention, les capacités de communication par CPL du compteur, prévues pour communiquer avec l'amont du compteur, sont utilisées pour communiquer de façon bidirectionnelle avec l'aval du compteur.

Le fait d'avoir une communication bidirectionnelle entre les équipements et le compteur permet une communication aussi bien dans le sens descendant vers les équipements que dans le sens montant vers le compteur.

Les données « descendantes » provenant du compteur concernent à la fois les données de comptage collectées par le compteur, mais également les données du client, ou données contractuelles, telles que par exemple les données relatives au contrat ou encore les données d'occurrence d'une pointe mobile (données tarifaires, etc.).

Les données « descendantes » provenant du compteur facilitent en outre la mise en place de services améliorés à destination du consommateur final.

Ainsi, par exemple, il est désormais possible grâce à la présente invention de rendre accessible à tous les équipements d'une installation l'asservissement de fonctionnement selon les heures creuses, ce service étant aujourd'hui possible en pratique uniquement pour l'asservissement des ballons d'eau chaude.

Aucune des solutions proposées dans l'état de la technique n'offre de tels services directement au consommateur final.

Grâce aux différents services proposés, le consommateur peut, en fonction des données communiquées, prendre une décision sur sa consommation afin notamment de la réduire.

Le dispositif selon la présente invention permet en outre d'assurer une communication bidirectionnelle pérenne avec tous les équipements de l'installation, quel que soit le protocole de communication radio utilisé par ces équipements.

Cette souplesse garantit que le système de comptage une fois mis en place puisse continuellement « parler » avec les différents équipements de l'installation ; en effet, la technologie de communication déployée dans ces équipements a généralement des cycles de renouvellement très rapides et est donc susceptible d'évoluer dans le temps. Il est difficile aujourd'hui d'assurer l'interopérabilité des systèmes existants lorsque ceux-ci évoluent régulièrement.

De façon optionnelle, la première interface de communication est également configurée pour communiquer de façon bidirectionnelle avec un concentrateur.

Ainsi, cette première interface de communication permet de communiquer directement avec le concentrateur, et éventuellement de communiquer indirectement par l'intermédiaire du concentrateur avec un système d'information comptage.

Cette communication d'information au concentrateur et éventuellement au système d'information comptage permet de mettre à disposition du consommateur final sur une même interface utilisateur accessible facilement (par exemple une interface Web) l'ensemble des données provenant à la fois du compteur et des équipements.

Ceci permet d'enrichir les services associés en remontant vers le concentrateur puis vers le système d'information comptage, des informations venant des équipements, par exemple des informations sur la consommation de chaque équipement, ce qui permet par exemple de générer ultérieurement des services appropriés, du type services Web, en fonction notamment d'une consommation ou d'un pic de consommation de l'ensemble de l'installation ou d'un équipement en particulier.

Avantageusement, la première interface de communication est configurée pour utiliser un protocole de communications par courants porteurs en ligne à bande étroite du type CPL-G3.

L'utilisation d'un tel protocole permet d'uniformiser les communications entre les différentes entités qui sont en jeu, sans modifier structurellement l'existant.

Avantageusement, la deuxième interface de communication comporte au moins un module de communication sans fil agencé pour communiquer avec un ou plusieurs équipements selon un ou plusieurs protocoles de communication sans fil déterminé.

Dans une variante, le module de communication sans fil peut comprendre une clé radio amovible du type par exemple une clé USB apte à se connecter électriquement sur le dispositif.

Ainsi, dans un mode de réalisation avantageux, le dispositif selon la présente invention consiste par exemple en une prise CPL-G3 composée :
- d'une partie principale qui constitue la base du dispositif et qui est configurée pour communiquer en CPL-G3 avec le compteur et éventuellement avec le concentrateur, et
- d'une ou plusieurs clés radio qui sont branchées chacune sur une connectique USB de cette base.

Dans cette variante, le dispositif selon la présente invention est très simple d'utilisation et d'installation.

Le dispositif selon la présente invention comporte de préférence une intelligence embarquée.

A cet effet, dans une variante, il comporte un module informatique de traitement qui est configuré pour émettre une ou plusieurs données de pilotage via la deuxième interface de communication à destination du ou des équipements ; ces données de pilotage contiennent chacune au moins une information pour contrôler la consommation de fluide du ou des équipements.

Dans une variante, la ou les données de pilotage sont générées par le concentrateur ou par le système d'information comptage. Ces données de pilotage sont ensuite acheminées du concentrateur :
- soit au compteur qui les réachemine ensuite au dispositif, avec d'autres données de comptage utiles au pilotage,
- soit directement au dispositif, notamment dans le cas de données de pilotage complexes non gérées par le compteur tel que par exemple le plan de charge d'une borne pour véhicule électrique.

Dans ces deux cas, le module informatique sert de relai.

Dans une autre variante, le module informatique de traitement est configuré pour générer la ou les données de pilotage.

Dans cette variante, le module informatique de traitement est configuré de telle manière que la ou les données de pilotage sont générées en fonction d'au moins une donnée d'événement transmise par le compteur (ou par le concentrateur) via la première interface de communication ; cette dite au moins une donnée d'événement contient une information relative à un évènement (par exemple un changement tarifaire, ou une demande d'effacement qui par exemple sont déterminés par le compteur, le concentrateur et/ou le système d'information comptage).

Dans une autre variante qui peut éventuellement être combinée avec la précédente variante, le module informatique de traitement est configuré de telle manière que la ou les données de pilotage sont générées en fonction d'au moins une donnée d'équipement contenant une information relative à un ou plusieurs équipements (par exemple une quantité de fluide consommée ou encore une caractéristique de la consommation de fluide).

Avantageusement, ladite au moins une donnée d'équipement est transmise directement par le ou les équipements via la deuxième interface de communication.

Comme évoqué ci-dessus, la première interface de communication peut être configurée pour communiquer directement avec le concentrateur ; elle peut en outre éventuellement communiquer indirectement par l'intermédiaire du concentrateur avec un système d'information comptage.

Avantageusement, cette première interface de communication est configurée pour transmettre au concentrateur et éventuellement au système d'information comptage au moins une donnée d'état provenant dudit au moins un équipement et reçue par le dispositif via la deuxième interface de communication ; cette donnée d'état contient de au moins une information relative à l'état dudit au moins un équipement.

De préférence, la donnée d'état est une donnée générée par ledit au moins un équipement suite à la réception par ledit au moins un équipement de ladite au moins une donnée de pilotage.

Ainsi, quelle que soit la variante de pilotage, la fonction de remontée des informations venant des équipements vers le concentrateur puis vers le système d'information comptage permet un retour d'informations ou d'état des équipements ayant reçu ces données de pilotage.

Ces informations en retour permettent par exemple d'attester du bon déroulement de ce pilotage.

Par exemple, suite à un ordre dit « d'effacement », les informations relatives au comportement de l'équipement ou de sa consommation d'énergie pendant la durée de la période d'effacement et de son bon retour à son état normal à la fin de la période d'effacement seront renvoyées vers le concentrateur puis vers le système d'information comptage ; il est ainsi possible de détecter une éventuelle anomalie dans l'exécution de ce pilotage et de lancer une éventuelle action correctrice ou de générer une alerte.

Cette donnée d'état peut également être remontée périodiquement, sans pilotage (par exemple : une remontée périodique pour indiquer la consommation d'une « *Smartplug* » sur laquelle est branché un appareil). Le dispositif selon la présente invention peut comporter dans une variante un moyen d'affichage éventuellement communicant par liaison radio et configuré pour afficher des informations relatives à au moins un équipement.

Alternativement, les informations peuvent être affichées via un terminal de communication du type tablette numérique, « *Smartphone* » ou encore ordinateur muni de moyens de communication (Internet).

Les informations affichées peuvent concerner par exemple la consommation de fluide, des préconisations concernant la consommation, des informations sur la période tarifaire, sur la durée d'une période d'effacement, etc.

Ces informations peuvent venir :
- via la première interface, du système de comptage, c'est-à-dire du compteur, du concentrateur ou du système d'information comptage, et/ou
- via la deuxième interface, des équipements de l'installation.

Ainsi, par ses différents aspects structurels et fonctionnels, la présente invention permet de remédier aux différents inconvénients énoncés dans l'état de la technique en offrant un dispositif communicant facile à brancher, qui s'adapte à l'infrastructure existante, et qui propose de nombreux services d'information à destination du consommateur final et/ou de services de pilotage à distance des équipements d'une installation.

### Brève description des figures annexées

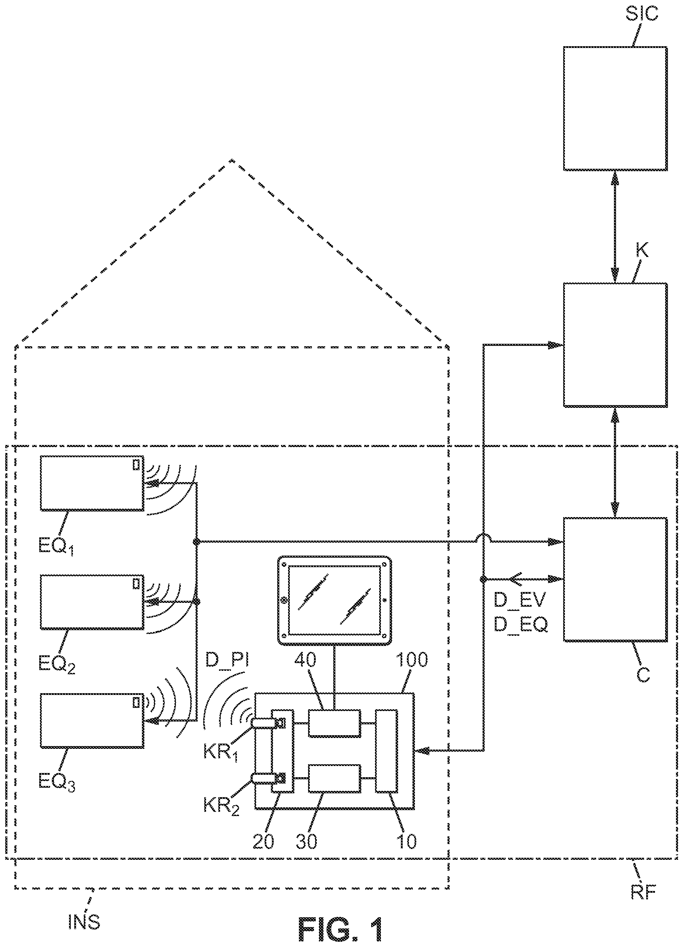

D'autres caractéristiques et avantages de la présente invention ressortiront de la description ci-dessous, en référence à l'unique figure 1 qui en illustre un exemple de réalisation dépourvu de tout caractère limitatif et sur laquelle est représenté de façon schématique un dispositif de communication selon un exemple de réalisation de la présente invention.

### Description détaillée d'un mode de réalisation de l'invention

Un dispositif de communication selon un mode de réalisation avantageux va maintenant être décrit dans ce qui suit en faisant référence à l'unique figure 1.

Permettre le déploiement de nouveaux services en aval du compteur à destination du consommateur final sans changer structurellement l'infrastructure de comptage existante est un des objectifs de la présente invention.

La fourniture d'une solution aux problématiques d'interopérabilité dans une installation telle qu'une habitation est également un des autres objectifs de la présente invention.

A cet effet, dans l'exemple décrit et comme illustré en figure 1, le dispositif de communication 100 selon la présente invention permet la communication entre les équipements EQ1, EQ2, et EQ3 d'une installation domestique ou habitation INS, un concentrateur K, un système d'information comptage SIC et un compteur de fluide C tel qu'un compteur d'énergie électrique configuré pour compter une quantité d'électricité consommée par l'ensemble des équipements de l'installation INS, incluant notamment EQ1, EQ2, et EQ3.

Dans l'exemple décrit ici et comme illustré en figure 1, les équipements EQ1, EQ2, et EQ3 et le compteur de fluide C sont reliés au réseau électrique RF de l'installation INS (représenté dans la figure 1 par les pointillés discontinus).

L'exemple décrit ici concerne plus particulièrement une installation domestique ; bien évidemment, comme évoqué précédemment, il s'agit d'un exemple purement illustratif et en aucun cas limitatif de sorte que l'homme du métier comprend ici qu'il peut s'agir de tous types d'installation.

De même, l'exemple décrit ici un compteur électrique C ; l'homme du métier comprendra ici qu'il peut s'agir de tous types de compteurs de fluide tels que définis dans le préambule de la description.

A titre illustratif, les équipements EQ1, EQ2, et EQ3 peuvent consister par exemple en : un chauffe eau, un radiateur électrique, une machine à laver, une pompe à chaleur, un réfrigérateur, une machine à laver, un capteur de présence, etc.

Bien évidemment, il peut s'agir d'autres équipements tels que par exemple un compteur annexe de gaz, un compteur annexe d'eau. Dans ce cas, ces équipements peuvent être assimilés à des équipements de l'installation au sens de la présente invention, pour autant que ces équipements (compteur annexe de gaz, un compteur annexe d'eau, etc.) soient aptes à communiquer, par exemple par liaison radio.

Dans cet exemple, le compteur C, le concentrateur K, qui forment ce qui est appelé communément le « *NAN* » (pour « *Neighbour Area Network »),* sont aptes à communiquer selon un protocole de communication du type CPL-G3.

Par ailleurs, le concentrateur K et le système d'information comptage SIC communiquent par un lien de type WAN (pour « *Wide Area Network* »), qui peut être constitué de tout type de liaison de communication longue distance, dont Internet.

Un des objectifs de la présente invention est de permettre une communication intelligente et un échange d'informations entre les différentes entités ci-dessus.

Ainsi, le dispositif de communication 100 selon la présente invention consiste en une passerelle d'informations disposée entre les équipements et le compteur de fluide ; dans l'exemple décrit ici, cette passerelle dispose d'une première 10 et d'une deuxième 20 interface de communication aptes à communiquer de façon bidirectionnelle avec ces différentes entités.

Dans l'exemple décrit ici et comme illustré en figure 1, la première interface 10 est configurée pour communiquer par courants porteurs en ligne selon le protocole CPL-G3 avec le compteur C.

D'autres protocoles à bande étroite sont envisageables comme par exemple le protocole PRIME.

Il est également possible d'envisager l'utilisation de protocoles à bande plus large tels que par exemple « *HomePlug GreenPHY™* ».

Dans cet exemple, la première interface 10 est en outre configurée pour communiquer par courants porteurs en ligne avec le concentrateur K. De même, cette première interface 10 est également configurée pour communiquer indirectement avec le système d'information comptage SIC par l'intermédiaire du concentrateur K et de la liaison WAN.

Dans l'exemple décrit ici et comme illustré en figure 1, la deuxième interface de communication 20 est configurée pour communiquer sans fil avec chaque équipement EQ1, EQ2, et EQ3.

A cet effet, dans l'exemple décrit, cette interface 20 comporte deux modules de communication sans fil qui consistent chacun en une clé radio KR1 et KR2 (ou « *Dongle* ») agencée chacune pour communiquer avec au moins un des équipements EQ1, EQ2, EQ3.

Bien évidemment, on comprendra ici que l'interface 20 peut comprendre plus de deux modules KR1 et KR2.

Ces modules KR1 et KR2 sont configurés pour communiquer avec ces équipements EQ1, EQ2, EQ3 selon une ou plusieurs technologies sans fil déterminées, par exemple « *W-Mbus* », « *Wfi*® », « *BlueTooth*® », « *IEEE802.15.4* » (encore appelée « *Zigbee* »), *« KNX »,* etc.

Ces modules KR1 et KR2, qui viennent se brancher sur les différentes connectiques USB du corps principal du dispositif 100, permettent aux éléments du « *HAN* » (pour « *Home Area Network* ») de communiquer entre eux, et de transmettre ou de recevoir des informations du « *NAN* », c'est-à-dire du compteur C et/ou du concentrateur K et donc, via le concentrateur K, du système d'information comptage SIC.

Le dispositif 100 selon la présente invention constitue ainsi une véritable interface de communication entre le « *HAN* » et le « *NAN* » et permet une communication bidirectionnelle d'informations entre ces deux entités, ce qui accroît la synergie entre le « *HAN* » et le « *NAN* ».

Comme indiqué ci-dessus, dans l'exemple décrit ici, chacune des première 10 et deuxième 20 interfaces est configurée pour une communication bidirectionnelle, ce qui permet un transfert de données à la fois dans le sens descendant et dans le sens montant, ce qui n'est pas prévu dans les différentes solutions envisagées jusqu'à présent dans l'état de la technique.

Le dispositif 100 s'intègre dans le système de comptage existant, et conserve la sécurisation des échanges CPL avec le compteur C et le concentrateur K : le protocole d'application COSEM/DLMS est utilisé de préférence à cet effet.

Pour rendre des services intelligents, ce qui est un des objectifs de la présente invention, le dispositif de communication 100 comporte un module informatique de traitement 30 qui est configuré pour relayer ou générer au moins une donnée de pilotage D_PI.

Comme illustré en figure 1, cette donnée de pilotage D_PI, qui est émise via la deuxième interface de communication 20 à destination d'un ou plusieurs équipements EQ1, EQ2, EQ3, contient une ou plusieurs informations (par exemple une information d'ordres) pour contrôler la consommation de fluide.

Le fait que la communication soit bidirectionnelle permet ainsi :
- dans un sens descendant, la transmission d'un ou plusieurs ordres, tels que par exemple un ordre d'effacement et/ou un ordre de réduction de consommation aux heures pleines, directement aux équipements EQ1, EQ2, EQ3 par l'intermédiaire d'une ou plusieurs données de pilotage D_PI, et
- dans un sens montant, la transmission vers le compteur C ou le concentrateur K d'informations spécifiques (comme par exemple dans le document FR 2 808 149 avec l'application DAL), et/ou d'informations autres que la relève de la consommation électrique (par exemple une relève de consommation de gaz ou d'eau qui transite via un compteur annexe de gaz ou d'eau apte à communiquer avec le dispositif 100 via la deuxième interface 20 ou encore la relève de la consommation électrique détaillée d'un équipement fournie par l'équipement lui-même ou fournie par la prise compteuse communicante du type « *SmartPlug* » sur laquelle est branché l'équipement).

Il est également possible que des informations de consommation (en électricité, en gaz, en eau ou autre) soient transmises par le compteur C dans le sens descendant pour permettre un affichage sur un écran numérique déporté 40.

Dans l'exemple décrit ici, la donnée de pilotage D_PI est générée par le module informatique de traitement 30 en prenant en considération un ou plusieurs paramètres extérieurs tels que par exemple une donnée d'événement D_EV transmise par le compteur C via la première interface de communication 10.

Il peut s'agir par exemple d'une donnée d'événement D_EV qui contient une information relative à un évènement : un changement tarifaire, un pic de consommation, une période d'effacement, etc.

Dans l'exemple décrit ici, la donnée de pilotage D_PI peut également être générée par le module informatique de traitement 30 en prenant en considération des informations provenant d'un ou plusieurs équipements telles que par exemple une donnée d'équipement D_EQ contenant par exemple une information relative à la consommation électrique d'un équipement, cette donnée d'équipement est transmise directement par l'équipement via la deuxième interface de communication 20.

Il est donc possible grâce à la présente invention de gérer la consommation en énergie des équipements grâce à une intelligence embarquée dans le module 30.

Alternativement, la donnée de pilotage D_PI peut également être générée par le concentrateur K ou le système d'information comptage SIC. Dans ce cas, le module 30 sert uniquement de relai pour la transmission de la donnée de pilotage D_PI vers les équipements EQ1, EQ2, EQ3 concernés.

Cette interface 100 permet la communication de tout type d'information ; il est dès lors possible d'envisager qu'en fonction d'une information provenant d'un capteur de présence, le module 30 traite l'information et pilote un équipement tel qu'un chauffage électrique, le tout en prenant en considération la période tarifaire.

Comme évoqué ci-dessus, grâce à la bidirectionnalité, il est également possible, par voie de retour, de détecter la présence d'une anomalie dans l'exécution d'un ordre issu d'une donnée de pilotage.

L'architecture décrite ci-dessus est donc prévue notamment pour transmettre des informations du compteur C vers les équipements ; la sécurisation de ces informations étant assurée en utilisant par exemple une architecture du type DLMS dans laquelle le compteur C est « client » et le dispositif 100 est « serveur ». C'est donc ici le compteur C qui initie la communication et le dispositif 100 ne dispose pas de services d'écriture vers le compteur. Toutefois, il est prévu que le dispositif puisse initier une communication avec le compteur afin de l'informer de certaines demandes en provenance des équipements (par exemple en provenance d'un dispositif d'affichage ou d'un écran).

L'homme du métier comprendra de la description que de nombreuses applications avantageuses peuvent être envisagées dans le cadre de la présente invention, le dispositif 100 constituant un véritable appareil de domotique pour gérer les équipements d'une installation et pour établir une véritable synergie entre l'ensemble du système de comptage (formé par l'ensemble compteurs, concentrateurs et système d'information comptage) et les équipements de l'installation.

L'affichage de services liés au système de comptage est également envisageable grâce à l'écran 40 qui vient s'interfacer avec l'utilisateur et qui permet un affichage des informations du type consommation et des services qui y sont associés, notamment les recommandations et les conseils en matière de consommation en énergie.

Il est également possible de prévoir une variante de réalisation de la présente invention dans laquelle les informations délivrées par le comptage à destination des équipements du « *HAN* » proviennent directement du concentrateur K, et toutes les requêtes à destination du comptage et provenant du « *HAN* » se font vers le concentrateur K. Dans ce cas, si le concentrateur K ne possède pas les données, le concentrateur K fait à son tour une requête vers le compteur C pour obtenir la donnée demandée, et la fait ensuite suivre vers les équipements du « *HAN* » à destination de l'équipement concerné.

Selon la présente invention, le dispositif 100 et le compteur C doivent être préalablement habilités à communiquer ensemble, de façon à assurer que le dispositif 100 n'accède qu'aux données du compteur C de l'installation INS et non d'une installation voisine, et que le compteur C n'envoie ses données qu'au dispositif 100 situé dans la même installation INS que celle où se trouve le compteur. ; la présente invention prévoit donc une procédure d'authentification par appairage par laquelle le concentrateur K communique au compteur C et au dispositif 100 les données d'identification et d'authentification les autorisant à communiquer entre eux.

Dans le cadre de la présente invention, il est également prévu que toutes les dispositions soient prises pour réduire la volumétrie des flux d'informations, notamment :
- entre le dispositif de communication et le compteur et/ou le concentrateur, et/ou
- entre les modules de communication et les équipements de l'installation.

Ainsi, la communication d'informations entre le dispositif de communication et le compteur se fait principalement lorsque les données à échanger sont pertinentes, par exemple lorsqu'elles changent ; c'est-à-dire par exemple lorsque ces données ne sont pas à variation continue (exemple : un numéro d'index en cours qui change lorsqu'on change de période tarifaire), ou encore lorsque ces données franchissent un seuil prédéterminé. Ainsi, à titre d'exemple, l'information relative à la consommation de puissance en Watts-heure (Wh) n'est pas transmise à chaque fois qu'elle augmente de 1 Wh mais par exemple seulement tous les 10, 20, 50 Wh.

De la même façon, les données de puissance instantanées en Volt-Ampère (VA) sont transmises de façon intelligente (pas de transmission lors d'un changement négligeable, à la hausse comme à la baisse).

Ce traitement intelligent peut être fait au niveau du compteur ou au niveau du dispositif de communication, selon les contraintes de débit existant sur les liaisons radio entre les modules de communication et les équipements de l'installation, et/ou sur la liaison CPL entre le dispositif de communication et le compteur et/ou le concentrateur.

D'autre part, le dispositif de communication selon la présente invention est configuré pour émettre des requêtes à destination du compteur, lorsque celui-ci n'émet plus de données, pour obtenir une information déterminée pendant un laps de temps déterminé.

Il devra être observé que cette description détaillée porte sur un exemple de réalisation particulier de la présente invention, mais qu'en aucun cas cette description ne revêt un quelconque caractère limitatif à l'objet de l'invention ; bien au contraire, elle a pour objectif d'ôter toute éventuelle imprécision ou toute mauvaise interprétation des revendications qui suivent.

## Revendications

1. Architecture de communication bidirectionnelle de flux de données comportant ::
- au moins un équipement (EQ1, EQ2, EQ3) d'une installation (INS), et
- un système de comptage comprenant un compteur de fluide (C) pour compter une quantité de fluide consommée par ledit au moins un équipement (EQ1, EQ2, EQ3) et un concentrateur (K),
ledit au moins un équipement (EQ1, EQ2, EQ3) et ledit compteur de fluide (C) étant reliés à un réseau de fluide (RF) de l'installation (INS),
ladite architecture comportant en outre un dispositif de communication (100) faisant l'interface entre ledit au moins un équipement (EQ1, EQ2, EQ3) et ledit système de comptage et comprenant :
- une première interface de communication (10) configurée pour communiquer par courants porteurs en ligne avec le compteur (C) et/ou ledit concentrateur (K), et
- une deuxième interface de communication (20) configurée pour communiquer sans fil avec ledit au moins un équipement (EQ1, EQ2, EQ3), chacune des première (10) et deuxième (20) interfaces étant configurée pour une communication bidirectionnelle des flux de données entre ledit au moins un équipement (EQ1, EQ2, EQ3) et ledit système de comptage.

2. Architecture selon la revendication 1, dans laquelle ledit système de comptage comprend en outre un système d'information comptage (SIC) et dans laquelle la première interface de communication (10) est configurée pour communiquer indirectement avec ledit système d'information comptage (SIC) par l'intermédiaire dudit concentrateur (K).

3. Architecture selon la revendication 1 ou 2, dans laquelle la première interface de communication (10) est configurée pour utiliser un protocole de communications par courants porteurs en ligne à bande étroite du type CPL-G3.

4. Architecture selon la revendication 3, dans laquelle la communication bidirectionnelle des flux de données entre le compteur (C), le concentrateur (K) et le dispositif (100) est sécurisée par un protocole d'application COSEM/DLMS.

5. Architecture selon l'une quelconque des revendications précédentes, dans laquelle la deuxième interface de communication (20) comporte au moins un module de communication sans fil (KR1, KR2) agencé pour communiquer avec ledit au moins un équipement (EQ1, EQ2, EQ3) selon un ou plusieurs protocoles de communication sans fil déterminé.

6. Architecture selon la revendication 5, dans laquelle ledit au moins un module de communication sans fil (KR1, KR2) comprend une clé radio amovible du type clé USB apte à se connecter électriquement sur ledit dispositif.

7. Architecture selon l'une quelconque des revendications précédentes, dans laquelle ledit dispositif (100) comporte un module informatique de traitement (30) configuré pour émettre au moins une donnée de pilotage (D_PI) à destination dudit au moins un équipement (EQ1, EQ2, EQ3) via la deuxième interface de communication (20), cette dite au moins une donnée de pilotage (D_PI) contenant au moins une information pour contrôler la consommation de fluide par ledit au moins un équipement (EQ1, EQ2, EQ3).

8. Architecture selon la revendication 7, dans laquelle le module informatique de traitement (30) est configuré pour générer ladite au moins une donnée de pilotage (D_PI) en fonction d'au moins une donnée d'événement (D_EV) transmise par le compteur (C) ou par le concentrateur via la première interface de communication (10) et contenant une information relative à un évènement, tel que par exemple un changement tarifaire déterminé par le compteur (C), le concentrateur (K) et/ou le système d'information comptage (SIC).

9. Architecture selon la revendication 7 ou 8, dans laquelle le module informatique de traitement (30) est configuré pour générer ladite au moins une donnée de pilotage (D_PI) en fonction d'au moins une donnée d'équipement (D_EQ) contenant au moins une information relative audit au moins un équipement (EQ1, EQ2, EQ3), tel que par exemple une quantité de fluide consommée ou une caractéristique de la consommation de fluide.

10. Architecture selon la revendication 9, dans laquelle la donnée d'équipement (D_EQ) est transmise directement par ledit au moins un équipement (EQ1, EQ2, EQ3) via la deuxième interface de communication (20).

11. Architecture selon l'une quelconque des revendications 7 à 10, dans laquelle la première interface de communication (10) est configurée pour transmettre directement audit concentrateur (K) au moins une donnée d'état provenant dudit au moins un équipement (EQ1, EQ2, EQ3) et contenant au moins une information relative à l'état dudit au moins un équipement (EQ1, EQ2, EQ3), ladite au moins une donnée d'état étant générée par ledit au moins un équipement (EQ1, EQ2, EQ3) suite à la réception par ledit au moins un équipement (EQ1, EQ2, EQ3) de ladite au moins une donnée de pilotage (D_PI).

12. Architecture selon l'une quelconque des revendications précédentes, comportant un moyen d'affichage (40) configuré pour afficher des informations provenant :
- via la première interface (10), du système de comptage, et/ou
- via la deuxième interface, dudit au moins un équipement (EQ1, EQ2, EQ3).

13. Architecture selon l'une quelconque des revendications précédentes, dans laquelle on réalise un appairage sur ladite architecture de manière à ce que le concentrateur (K) communique au compteur (C) et au dispositif (100) des données d'identification et d'authentification les autorisant à communiquer entre eux.

14. Dispositif de communication bidirectionnelle de flux de données entre :
- au moins un équipement (EQ1, EQ2, EQ3) d'une installation (INS), et
- un système de comptage comprenant un compteur de fluide (C) pour compter une quantité de fluide consommée par ledit au moins un équipement (EQ1, EQ2, EQ3) et un concentrateur (K),
ledit au moins un équipement (EQ1, EQ2, EQ3) et ledit compteur de fluide (C) étant reliés à un réseau de fluide (RF) de l'installation (INS),
dans lequel ledit dispositif de communication (100), faisant l'interface entre ledit au moins un équipement (EQ1, EQ2, EQ3) et ledit système de comptage, comporte :
- une première interface de communication (10) configurée pour communiquer par courants porteurs en ligne avec le compteur (C) et/ou ledit concentrateur (K), et
- une deuxième interface de communication (20) configurée pour communiquer sans fil avec ledit au moins un équipement (EQ1, EQ2, EQ3),
chacune des première (10) et deuxième (20) interfaces étant configurée pour une communication bidirectionnelle des flux de données entre ledit au moins un équipement (EQ1, EQ2, EQ3) et ledit système de comptage.

## Patentansprüche

1. Bidirektionale Datenstrom-Kommunikationsarchitektur, umfassend:
- wenigstens eine Ausrüstung (EQ1, EQ2, EQ3) einer Anlage (INS) und
- ein Zählsystem umfassend einen Flüssigkeitszähler (C) zum Zählen einer von der wenigstens einen Ausrüstung (EQ1, EQ2, EQ3) verbrauchten Flüssigkeitsmenge und einen Konzentrator (K),
wobei die wenigstens eine Ausrüstung (EQ1, EQ2, EQ3) und der Flüssigkeitszähler (C) mit einem Flüssigkeitsnetz (RF) der Anlage (INS) verbunden sind,
wobei die Architektur ferner eine die Schnittstelle zwischen der wenigstens einen Ausrüstung (EQ1, EQ2, EQ3) und dem Zählsystem bildende Kommunikationsvorrichtung (100) umfasst, umfassend:
- eine zum Kommunizieren durch Trägerfrequenzanlage mit dem Zähler (C) und/oder dem Konzentrator (K) ausgebildete erste Kommunikationsschnittstelle (10), und
- eine zum drahtlosen Kommunizieren mit der wenigstens einen Ausrüstung (EQ1, EQ2, EQ3) ausgebildete zweite Kommunikationsschnittstelle (20), wobei jede der ersten (10) und zweiten (20) Schnittstelle für eine bidirektionale Datenstromkommunikation zwischen der wenigstens einen Ausrüstung (EQ1, EQ2, EQ3) und dem Zählsystem ausgebildet ist.

2. Architektur nach Anspruch 1, wobei das Zählsystem ferner ein Zählinformationssystem (SIC) umfasst und wobei die erste Kommunikationsschnittstelle (10) zum indirekten Kommunizieren mit dem Zählinformationssystem (SIC) über den Konzentrator (K) ausgebildet ist.

3. Architektur nach Anspruch 1 oder 2, wobei die erste Kommunikationsschnittstelle (10) zum Verwenden eines Kommunikationsprotokolls per Schmalband-Trägerfrequenzanlage des Typs CPL-G3 ausgebildet ist.

4. Architektur nach Anspruch 3, wobei die bidirektionale Datenstromkommunikation zwischen dem Zähler (C), dem Konzentrator (K) und der Vorrichtung (100) durch ein COSEM/DLMS-Anwendungsprotokoll abgesichert ist.

5. Architektur nach einem der vorhergehenden Ansprüche, wobei die zweite Kommunikationsschnittstelle (20) wenigstens ein zum Kommunizieren mit wenigstens einer Ausrüstung (EQ1, EQ2, EQ3) nach einem oder mehreren vorgegebenen Drahtloskommunikationsprotokollen ausgebildetes Drahtloskommunikationsmodul (KR1, KR2) umfasst.

6. Architektur nach Anspruch 5, wobei das wenigstens eine Drahtloskommunikationsmodul (KR1, KR2) einen zum elektrischen Anschließen an die Vorrichtung ausgebildeten abnehmbaren Funkstick in USB-Stick-Ausführung umfasst.

7. Architektur nach einem der vorhergehenden Ansprüche, wobei die Vorrichtung (100) ein zum Senden von wenigstens einem Steuerdatum (D_PI) für die wenigstens eine Ausrüstung (EQ1, EQ2, EQ3) über die zweite Kommunikationsschnittstelle (20) ausgebildetes Verarbeitungsinformatikmodul (30) umfasst, wobei dieses wenigstens eine Steuerdatum (D_PI) wenigstens eine Information zum Steuern des Flüssigkeitsverbrauchs durch die wenigstens eine Ausrüstung (EQ1, EQ2, EQ3) enthält.

8. Architektur nach Anspruch 7, wobei das Verarbeitungsinformatikmodul (30) zum Erzeugen des wenigstens einen Steuerdatums (D_PI) entsprechend wenigstens einem vom Zähler (C) oder vom Konzentrator über die erste Kommunikationsschnittstelle (10) gesendeten und eine Information in Bezug auf ein Ereignis wie beispielsweise eine vom Zähler (C), vom Konzentrator (K) und/oder vom Zählinformationssystem (SIC) ermittelte Tarifänderung enthaltenden Ereignisdatum (D_EV) ausgebildet ist.

9. Architektur nach Anspruch 7 oder 8, wobei das Verarbeitungsinformatikmodul (30) zum Erzeugen des wenigstens einen Steuerdatums (D_PI) entsprechend wenigstens einem wenigstens eine Information in Bezug auf die wenigstens eine Ausrüstung (EQ1, EQ2, EQ3) wie beispielsweise eine verbrauchte Flüssigkeitsmenge oder ein Merkmal des Flüssigkeitsverbrauchs enthaltenden Ausrüstungsdatum (D_EQ) ausgebildet ist.

10. Architektur nach Anspruch 9, wobei das Ausrüstungsdatum (D_EQ) direkt von der wenigstens einen Ausrüstung (EQ1, EQ2, EQ3) über die zweite Kommunikationsschnittstelle (20) gesendet wird.

11. Architektur nach einem der Ansprüche 7 bis 10, wobei die erste Kommunikationsschnittstelle (10) zum direkten Senden von wenigstens einem von der wenigstens einen Ausrüstung (EQ1, EQ2, EQ3) stammenden und wenigstens eine Information in Bezug auf den Zustand der wenigstens einen Ausrüstung (EQ1, EQ2, EQ3) enthaltenden Zustandsdatum an den Konzentrator (K) ausgebildet ist, wobei das wenigstens eine Zustandsdatum von der wenigstens einen Ausrüstung (EQ1, EQ2, EQ3) nach dem Empfang des wenigstens einen Steuerdatums (D_PI) durch die wenigstens eine Ausrüstung (EQ1, EQ2, EQ3) erzeugt wird.

12. Architektur nach einem der vorhergehenden Ansprüche, umfassend ein zum Anzeigen der Informationen ausgebildetes Anzeigemittel (40), stammend:
- über die erste Schnittstelle (10) vom Zählsystem, und/oder
- über die zweite Schnittstelle von der wenigstens einen Ausrüstung (EQ1, EQ2, EQ3).

13. Architektur nach einem der vorhergehenden Ansprüche, wobei ein Pairing auf der Architektur durchgeführt wird, so dass der Konzentrator (K) an den Zähler (C) und an die Vorrichtung (100) Identifikations- und Authentifizierungsdaten zum Autorisieren dieser zum Kommunizieren untereinander kommuniziert.

14. Bidirektionale Datenstrom-Kommunikationsvorrichtung, umfassend:
- wenigstens eine Ausrüstung (EQ1, EQ2, EQ3) einer Anlage (INS), und
- ein Zählsystem umfassend einen Flüssigkeitszähler (C) zum Zählen einer von der wenigstens einen Ausrüstung (EQ1, EQ2, EQ3) verbrauchten Flüssigkeitsmenge und einen Konzentrator (K),
wobei die wenigstens eine Ausrüstung (EQ1, EQ2, EQ3) und der Flüssigkeitszähler (C) mit einem Flüssigkeitsnetz (RF) der Anlage (INS) verbunden sind, wobei die als Schnittstelle zwischen der wenigstens einen Ausrüstung (EQ1, EQ2, EQ3) und dem Zählsystem dienende Kommunikationsvorrichtung (100) umfasst:
- eine zum Kommunizieren durch Trägerfrequenzanlage mit dem Zähler (C) und/oder dem Konzentrator (K) ausgebildete erste Kommunikationsschnittstelle (10), und
- eine zum drahtlosen Kommunizieren mit der wenigstens einen Ausrüstung (EQ1, EQ2, EQ3) ausgebildete zweite Kommunikationsschnittstelle (20),
wobei jede der ersten (10) und zweiten (20) Schnittstelle für eine bidirektionale Datenstromkommunikation zwischen der wenigstens einen Ausrüstung (EQ1, EQ2, EQ3) und dem Zählsystem ausgebildet ist.

## Claims

1. Architecture for bidirectional communication of data streams, comprising:
- at least one equipment item (EQ1, EQ2, EQ3) of an installation (INS), and
- a metering system comprising : a fluid meter (C) for measuring an amount of fluid consumed by said at least one equipment item (EQ1, EQ2, EQ3), and a concentrator (K),
said at least one equipment item (EQ1, EQ2, EQ3) and said fluid meter (C) being connected to a fluid distribution network (RF) of the installation (INS), said architecture further comprising a communication device (100) interfacing between said at least one equipment item (EQ1, EQ2, EQ3) and said metering system, and comprising:
- a first communication interface (10) configured for communicating by power-line carrier with the meter (C) and/or said concentrator (K), and
- a second communication interface (20) configured for communicating wirelessly with said at least one equipment item (EQ1, EQ2, EQ3), each of the first (10) and second (20) interfaces being configured for bidirectional communication of data streams between said at least one equipment item (EQ1, EQ2, EQ3) and said metering system.

2. Architecture according to claim 1, wherein said metering system further comprises a metering information system (MIS) and wherein said first communication interface (10) is configured for indirect communication with said metering information system (MIS) by means of the concentrator (K).

3. Architecture according claim 1 or 2, wherein the first communication interface (10) is configured to use a narrowband power-line communications protocol such as G3-PLC.

4. Architecture according to claim 3, wherein the bidirectional communication of data streams between the meter (C), the concentrator (K), and the device (100) is secured by a COSEM/DLMS application protocol.

5. Architecture according to any one of preceding claims, wherein the second communication interface (20) comprises at least one wireless communication module (KR1, KR2) arranged to communicate with said at least one equipment item (EQ1, EQ2, EQ3) according to one or more predefined wireless communication protocols.

6. Architecture according to claim 5, wherein said at least one wireless communication module (KR1, KR2) comprises a removable radio dongle such as a USB dongle adapted to connect to said device electrically.

7. Architecture according to any one of the preceding claims, wherein it comprises a processing module (30) configured to transmit at least one control data item (D_PI) to said at least one equipment item (EQ1, EQ2, EQ3) via the second communication interface (20), said at least one control data item (D_PI) containing at least one information item for controlling fluid consumption by said at least one equipment item (EQ1, EQ2, EQ3).

8. Architecture according to claim 7, wherein the processing module (30) is configured to generate said at least one control data item (D_PI) based on at least one event data item (D_EV) transmitted by the meter (C) or by the concentrator via the first communication interface (10) and containing information relating to an event, for example such as a rate change determined by the meter (C), the concentrator (K), and/or the metering information system (MIS).

9. Architecture according to claim 7 or 8, wherein the processing module (30) is configured to generate said at least one control data item (D_PI) based on at least one equipment data item (D_EQ) containing at least one information item relating to said at least one equipment item (EQ1, EQ2, EQ3), for example such as an amount of fluid consumed or a fluid consumption characteristic.

10. Architecture according to claim 9, wherein the equipment data item (D_EQ) is transmitted directly by said at least one equipment item (EQ1, EQ2, EQ3) via the second communication interface (20).

11. Architecture according to any one of the claims 7 to 10, wherein the first communication interface (10) is configured to transmit directly to said concentrator (K) at least one status data item originating from said at least one equipment item (EQ1, EQ2, EQ3) and containing at least one information item relating to the status of said at least one equipment item (EQ1, EQ2, EQ3), said at least one status data item being generated by said at least one equipment item (EQ1, EQ2, EQ3) following receipt by said at least one equipment item (EQ1, EQ2, EQ3) of said at least one control data item (D_PI).

12. Architecture according to any one of the preceding claims, comprising a display means (40) configured for displaying information originating from :
- the metering system, via the first interface (10), and/or
- said at least one equipment item (EQ1, EQ2, EQ3), via the second interface.

13. Architecture according to any one of the preceding claims, wherein peering is provided in said architecture such that the concentrator (K) communicates to the meter (C) and to the device (100) the identification and authentication data allowing them to communicate with each other.

14. Device for bidirectional communication of data streams between:
at least one equipment item (EQ1, EQ2, EQ3) of an installation (INS), and
a metering system comprising: a fluid meter (C) for measuring an amount of fluid consumed by said at least one equipment item (EQ1, EQ2, EQ3), and a concentrator (K),
said at least one equipment item (EQ1, EQ2, EQ3) and said fluid meter (C) being connected to a fluid distribution network (RF) of the installation (INS),
wherein said communication device (100) interfacing between said at least one equipment item (EQ1, EQ2, EQ3) and said metering system comprises:
- a first communication interface (10) configured for communicating by power-line carrier with the meter (C) and/or with said concentrator (K), and
- a second communication interface (20) configured for communicating wirelessly with said at least one equipment item (EQ1, EQ2, EQ3),
each of the first (10) and second (20) interfaces being configured for bidirectional communication of data streams between said at least one equipment item (EQ1, EQ2, EQ3) and said metering system.
